(19) Europäisches Patentamt

European Patent Office

Office européen des brevets

(11) EP 0 408 238 B1

(12) EUROPEAN PATENT SPECIFICATION

(45) Date of publication and mention
of the grant of the patent:
27.03.1996 Bulletin 1996/13

(51) Int Cl.⁶: **H03C 3/09**, H03L 7/197, H04L 27/20

(21) Application number: 90307270.0

(22) Date of filing: 03.07.1990

(54) **A frequency synthesiser**

Frequenzsynthesizer

Synthétiseur de fréquence

(84) Designated Contracting States:
DE FR IT NL SE

(30) Priority: 08.07.1989 GB 8915719
22.09.1989 GB 8921444

(43) Date of publication of application:
16.01.1991 Bulletin 1991/03

(73) Proprietor: PLESSEY SEMICONDUCTORS LIMITED
Swindon, Wiltshire SN2 2QW (GB)

(72) Inventor: **Johnson, David Antony**
**Wickham, Hampshire (GB)**

(74) Representative: **Hoste, Colin Francis et al**
**The General Electric Company p.l.c.**
**GEC Patent Department**
**Waterhouse Lane**
**Chelmsford, Essex CM1 2QX (GB)**

(56) References cited:
EP-A- 0 073 699          EP-A- 0 322 139
WO-A-86/00767           GB-A- 2 046 541
US-A- 4 052 672          US-A- 4 068 198
US-A- 4 242 649          US-A- 4 543 542
US-A- 4 810 977

## Description

### FIELD OF THE INVENTION

This invention relates to frequency synthesis, in particular direct modulation of a frequency synthesiser to produce wide band modulation. The present invention has particular though not exclusive application to cellular radio, for mobile telephone systems, and especially the GSM (Groupe Speciale Mobile) system.

### BACKGROUND ART

In the GSM system, data to be transmitted is modulated onto a 900 MHz carrier by a Gaussian minimum shift keying technique (GMSK). GMSK is a form of continuous phase frequency shift keying in which the modulating data is subject to a Gaussian low pass filter. Frequency Channels are provided at a spacing of 200 kHz and data is transmitted on each channel at a total rate of 270.833 kbits$^{-1}$.

One major problem is that of modulation of data onto the UHF carrier wave. GMSK modulation produces a lower spectral occupancy than frequency shift keying or differential phase modulation. In GSM, the data transmission rate (270.833 kbit/s) is higher than the channel spacing (200 kHz). The bandwidth of the signal must be less than 200 kHz, and this makes the task of modulation difficult.

Normally a phase lock loop system is employed for frequency synthesis so that the transmission frequency as synthesised by the frequency synthesiser can rapidly be changed between channels by changing the division ratio. Conventional methods of modulation, such as modulating the frequency produced by a crystal and then mixing that signal with a UHF signal produced from a synthesiser are too bulky and expensive to be employed in say a user hand set of a mobile telephone. Methods have therefore been developed for modulating directly the phase lock loop. One method which is employed for direct modulation is to modulate the phase of a reference crystal oscillator for the phase lock loop. However the problem here is that modulation frequencies are required down to DC and up to around 250 kHz. The high frequency modulations will be filtered out by the filters within the phase lock loop. Another method is direct modulation of the VCO in the phase locked loop. Here however the low frequency modulations are filtered out by the loop.

A method which has been employed to overcome these problems of modulation in phase lock loops is known as two-point modulation.

Two-point modulation schemes have been employed with modulation of the ÷N divider and the control input of the VCO. For example US 4,543,542, US 4,810,977 and EP 0322139 disclose analog FM modulation of a frequency synthesiser in test equipment. The analog modulating signal is applied via an A/D converter to a ÷N divider. GB 2046541 discloses direct modulation of a freqency synthesiser by digital (binary level) modulation with the modulating signal applied direct to the ÷N divider and via a D/A converter and low pass filter to a control input of the VCO. In this way, a simple frequency shift keying of the output signal is achieved, for example for a teleprinter. US 4,492,936 also discloses modulation of a frequency synthesiser by digital signals applied direct to the divider and by way of a D/A converter and filter to a control input of the VCO.

None of these known arrangements would be suitable for producing continuous phase modulation of a carrier frequency by application of digital modulating signals.

### SUMMARY OF THE INVENTION

It is an object of the present invention to provide an inexpensive means of modulating a frequency synthesiser, suitable for incorporation into a handset of a mobile/portable telephone system, and which desirably produces continuous phase modulated signals from a digital input modulating signal.

The present invention provides a frequency synthesiser comprising a voltage controlled oscillator, a reference oscillator, a divider circuit for dividing the frequency of an output signal from the voltage controlled oscillator by a variable division factor, a comparator for comparing an output signal from said divider circuit with an output signal from said reference oscillator to provide a control signal for said voltage controlled oscillator in a phase locked loop arrangement, means for applying a modulating signal with said control signal to a control input of said voltage controlled oscillator and integrator means for applying said modulating signal to control the variable division factor of said divider circuit, characterised in that the integrator means comprises an up/down counter the corny/borrow outputs of which are coupled to a further counter means the output of which in turn is coupled to the divider circuit, and that the count value of the up-down counter is applied to a circuit for producing a pulse of variable width which is applied by way of scaling means to a summing device for summing with the output of the comparator.

In accordance with the invention, where GMSK modulation is required, the means for applying the modulating signal to the control input of said voltage controlled oscillator may comprise a Gaussian low pass filter. Where other forms of continuous phase modulation (CPM) are required, e.g. a raised cosine modulation, an appropriate filter will be provided. For a description and definition of various types of CPM, reference is made to "Digital Phase Modulation" Anderson, Aulin, Sundberg, Plenum Press pp. 50-53. This reference includes a mathematical definition of CPM, but for present purposes it is sufficient to understand CPM as meaning a constant carrier wave envelope but with phase varying in a continuous manner.

It would be possible in accordance with the invention to provide minimum shift keying (fast frequency shift keying) wherein the modulation waveform usually has a phase quadrature form. It may be produced by providing a direction connection as the transfer function means.

Thus in accordance with the invention if a modulation input signal produces a phase or frequency change in the output of the voltage controlled oscillator, the modulation input signal is arranged to produce a corresponding change in the variable divider value N such that the divided value of frequency applied to the phase sensitive detector remains constant so that the phase sensitive detector does not experience any apparent change of frequency.

Thus, if a change in modulation input signal dR produces a change df in the VCO output signal f, and a change dN in the divider value N, then for a constant frequency value $f_N$ applied to the input of the phase sensitive detector:

$$f_N = \frac{f}{N} = \frac{f + df}{N + dN}$$
$$\therefore f(N + dN) = N(f + df)$$
$$fN + fdN = Nf + df$$

thus $\frac{dN}{N} = \frac{df}{f}$ for correction operation.

However in situations where the value of N is low, or the frequency deviations at the VCO output are small then it may not be possible to get sufficient resolution in the incremental value dN to provide appropriate compensation. Thus in accordance with a further feature of the invention an extra compensation signal with finer resolution may be added at an appropriate part of the circuit, for example the loop filter input.

BRIEF DESCRIPTION OF THE DRAWINGS

A preferred embodiment of the invention will now be described with reference to the accompanying drawings wherein:-

Figure 1 is a block schematic view of a phase lock loop of a freuency synthesiser according to the invention incorporating a two point modulation scheme; and,
Figure 2 is a more detailed block diagram of the frequency synthesiser of Figure 1.

BRIEF DESCRIPTION OF THE PREFERRED EMBODIMENTS

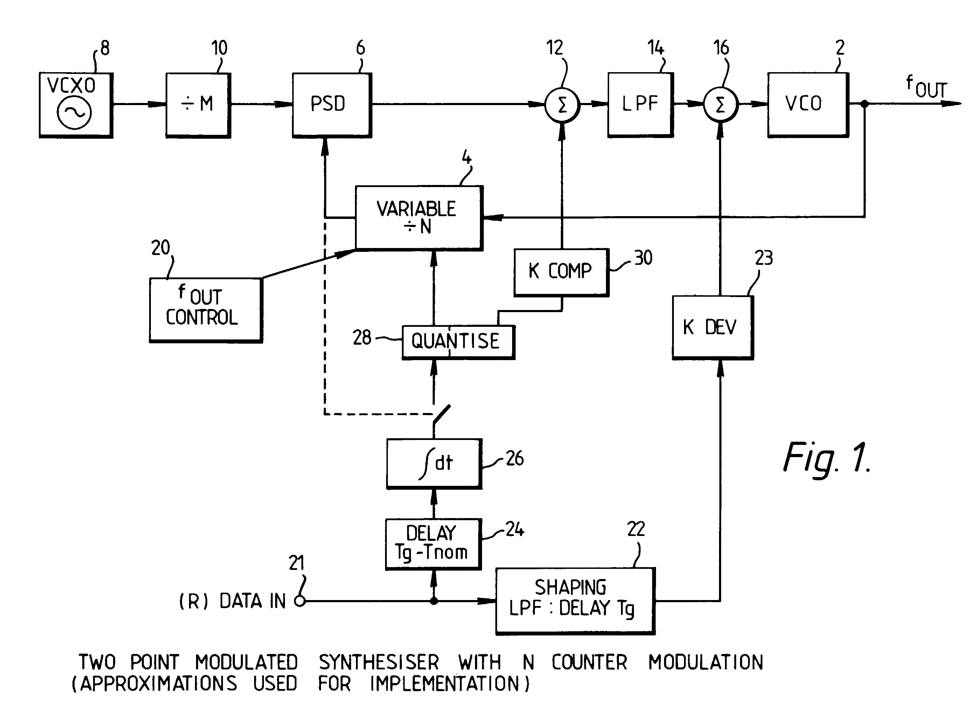

Referring now to Figure 1, the synthesiser according to the invention includes a phase locked loop wherein, a VCO 2 provides an output signal $f_{out}$, and this signal is fed back to a variable ÷M circuit 10 to a second input of detector 6. The output of the phase detector 6 is provided via a summing circuit 12 to the low pass filter 14 of the loop and then via a further summing circuit 16 to the control input of the VCO 2. Divider circuit 4 has the dividing number N determined via a control circuit 20. An input port 21 is provided for a modulating signal to be applied to the synthesiser. The modulating signal is in any convenient binary format for example NRZ. This binary data signal is applied via a Gaussian filter 22 and a scaling circuit 23 to the summing circuit 16 where the binary data, shaped by filter 22 is applied to the control input of oscillator 2. This therefore is the basic means by which modulation of the output frequency is produced and by employing a Gaussian filter, GMSK modulation is produced. In order to prevent the modulation in the output signal from adversely affecting detector 6, the input data signal is also applied via a delay circuit 24 to an integrator circuit 26 and a quantiser circuit 28. Delay circuit 24 is provided to compensate for the delay introduced by filter 22 relative to the delay in the units 26, 28. Integrator 26 which may be a simple accumulator or counter provides an output signal which is quantised at 28 so that the most significant bit is applied to the variable divider circuit 4 whereas the less significant bits are applied via a scaling circuit 30 to summer circuit 12.

Thus in operation of the invention, when modulation input signal R is applied this produces a signal RKdev which is summed at 16 with the signal from low pass filter 14 to produce a deviation in the output frequency of oscillator 2. In addition this modulation input signal is integrated to produce a phase change signal which is applied to divider N to produce an appropriate change in the value of N. It may be understood that a change in N is equivalent to a phase change in the divided signal $f_N$, since a single cycle of VCO output f when divided by N may be thought of in simple terms as equivalent to a phase change $N^{-1} * 2\pi$. This change in the value of N is arranged to cancel out the change in output frequency of oscillator 2 so that the signal applied to phase sensitive detector 6 remains constant. In situations where the absolute value of N is low, it may not be possible to produce a change in N which is sufficiently resolved to achieve appropriate compensation and in these circumstances the integrated value of phase change applied to via scaling circuit 30 to summing unit 12 produces a further correction in the output from phase sensitive detector 6 to compensate to the required degree of fine resolution.

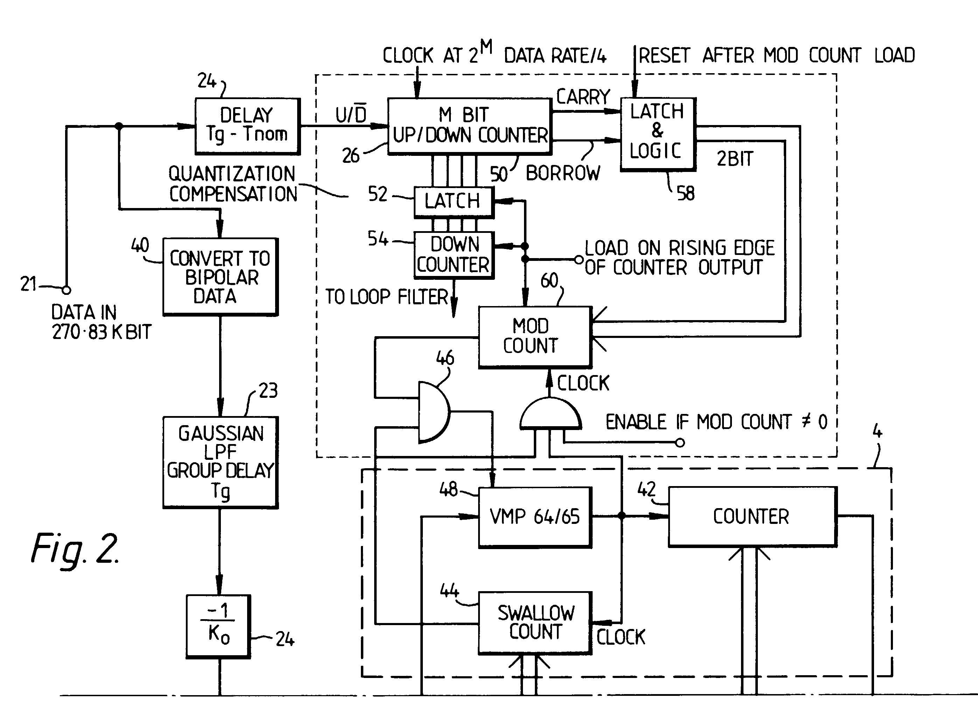

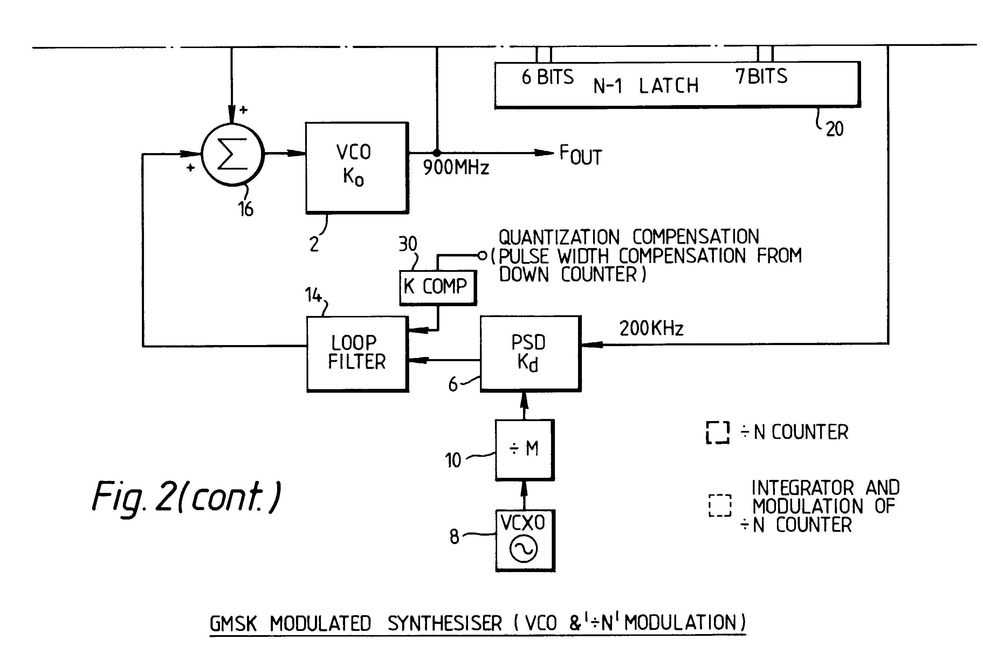

Referring now to Figure 2 this shows the circuit of Figure 1 in more detail and similar parts are denoted by the same reference numeral. The circuit of Figure 2 is specifically designed for the GSM system and data is input at the prescribed rate of 270.83 kbits per second in unipolar format. A bipolar conversion circuit 40 is coupled between input 21 and Gaussian filter 22.

Counter 4 is of the N/N+1 form in which a latch circuit 20 contains a 13 bit word determining the output frequency, which will be around 900 MHz. The most significant 7 bits of the frequency word are applied to a fixed counter 42. The less significant 6 bits are applied to a swallow counter 44 this provides an output via logic gate 46 to scaler circuit 48 which provides a 64/65 division facility. Counter 44 is clocked by the output of scaler circuit 48 so that when the counter counts to its maximum, the carry output changes to change the scaler circuit 48 from a divide by 64 capability to a divide by 65 capability. In this way counter 44 determines the time prescaler spends in divide by 64 mode relative to divide by 65 mode. This arrangement therefore provides the well known fractional N synthesiser. Scaler circuit 48 is also actuated by logic gate 46 by a control signal from accumulator/quantiser circuits 26/28. Counter circuit 26 is implemented as a M bit up/down counter 50. The output of the counter is applied via a latch circuit 52 and a down counter 54 to scaler circuit 30. The function of down counter 54 is to provide an output pulse having a width proportional to the value stored in latch 52 so that an output pulse is applied to loop 14 having a width proportional to the value in counter 50.

The carry and borrow outputs of counter 50 are applied as the most significant bits of the counter to a latch and logic circuit 58 which provides a 2 bit data output to a modulus counter 60. Counter 60 has a nominal value of 1. This counter is incremented by a 2 bit output from latch circuit 58 and a carry signal from counter 60 is used to enable logic gate 46. Thus it may be seen that the output of the prescaler 44 is modulated by the input data.

Thus in operation, latch 20 (and hence swallow counter 44) is loaded with a number (N-1), i.e one less than the nominal value required for the desired operating frequency of about 900 MHz. The nominal value of 1 in the modulating counter 60 supplies the extra digit required for the nominal operating frequency. Thus in normal operation without any modulating signal applied, swallow counter 44 determines the relative number of cycles that prescaler circuit 48 will divide by 64 and divide by 65. Since MOD counter 60 is clocked by the outputs of counter 44 and prescaler 48, gate 46 is arranged to provide an appropriate pulse signal, whose length is dependant on the value in MOD counter 60(01) to scaler 48, which effectively lengthens the period of time that prescaler 48 is in one count mode. This enables the desired operating frequency to be attained. In the situation where a modulating signal is applied via input 21, the value of counter 60 may change to 2 or 0 depending on the state of latch circuit 58. If the value of counter 60 is 2 then the pulse output of counter 60 is lengthened. This will increase the frequency provided by circuit 4. If however the value of the counter 60 is 0 then no enabling pulse will be provided to prescaler 48 and thus the frequency provided by circuit 4 will be decreased. This method of modulation is acceptable since only fairly small changes in frequency are envisaged (the modulation index = 0.5). This corresponds to a maximum phase change of $\pi/2$ per symbol period.

Thus in summary, in operation of the circuits of Figures 1 and 2, the synthesiser loop is modulated in two points with extra compensation at a third point.

Data is fed through a modulation shaping filter and then applied directly to the VCO. The modulation filter reduces the spectral occupancy of the resulting signal at the VCO output and its shape is dependent on the modulation scheme used, e.g. Gaussian shaping for GMSK.

The modulation on the VCO output is removed before reaching the phase detector, by modulating the N counter. A simple digital approximation to the shaping filter is used to reproduce the modulation (for certain modulation schemes this shaping approximation may be omitted completely whilst still giving an accurate enough representation of the modulation, e.g. GMSK). This approximation to the modulation is integrated digitally (using an up-down counter) and used to modulate the N counter thus removing the modulation on the VCO output.

Due to the fact that N is an integer and is only changed by ±1 on each reference cycle a third point of modulation is required. This removes the phase errors between the quantisation that modulating N imposes (N-1, N, N+1) i.e. phase errors of less that $\pm2\pi$ radians at RF.

The resulting signal is low pass filtered, this removes the high frequency phase errors caused by only using a simple approximation to the modulation shaping when modulating the ÷N counter.

The output of the low pass filter is then the loop error signal with no error due to modulating the VCO and the loop operates as if no modulation had been applied.

**Claims**

1. A frequency synthesiser comprising a voltage controlled oscillator (2), a reference oscillator (8), a divider circuit (4) for dividing the frequency of an output signal from the voltage controlled oscillator (2) by a variable division factor, a comparator (6) for comparing an output signal from said divider circuit (4) with an output signal from said reference oscillator (8) to provide a control signal for said voltage controlled oscillator (2) in a phase locked loop arrangement, means (16, 22, 23) for applying a modulating signal with said control signal to a control input of said voltage controlled oscillator (2) and integrator means (24, 26, 28) for applying said modulating signal to control the variable division factor of said divider circuit (4), characterised in that the integrator means (24, 26, 28) comprises an up/down counter (50) the carry/borrow outputs of which are coupled to a further counter means (60) the output of which in turn is coupled to the divider circuit (4), and that the count value of the up/down counter (50) is applied to a circuit (52, 54) for producing a pulse of variable width which is applied by way of scaling means (30) to a summing device (12) for summing with the output of the comparator (6).

2. A synthesiser in accordance with Claim 1 wherein the means (16, 22, 23) for applying the modulating signal with said control signal to a control input of said voltage controlled oscillator (2) comprises a Gaussian low pass filter (22) in order to produce GMSK modulation.

3. A synthesiser according to Claim 1 or Claim 2 wherein the divider circuit (4) includes control means (44, 46, 48) for producing division factors of N and N+ 1, and the output of said further counter means (60) is arranged to control the relative number of cycles of the divider circuit (4) during which the division factors N and N + 1 are utilised.

4. A synthesiser according to any preceding claim wherein the divider circuit (4) includes a first counter (42) for determining a nominal value for said division factor, a prescaler circuit (48) coupled to receive the output signal from the voltage controlled oscillator (2), and a swallow counter (44) for enabling the switching of the prescaler circuit (48) between modes determining division factors respectively of N + 1.

5. A synthesiser in accordance with Claim 4 wherein the further counter means (60) provides an output signal for controlling the switching of the prescaler circuit (48).

6. A synthesiser in accordance with Claim 5 wherein said further counter means (60) provides said output signal for controlling the switching of the prescaler circuit (48) in the form of a pulse whose length is dependent on the count value of said further counter means (60).

**Patentansprüche**

1. Frequenzsynthesizer mit einem spannungsgesteuerten Oszillator (2), einem Referenzoszillator (8), einem Umsetzschaltkreis (4) zum Frequenzumsetzen eines Ausgangssignals des spannungsgesteuerten Oszillators (2) durch einen veränderlichen Teilungsfaktor, einem Vergleicher (6) zum Vergeichen eines Ausgangssignals von dem Umsetzschaltkreis (4) mit einem Ausgangssignal von dem Referenzoszillator (8), um ein Steuersignal für den spannungsgesteuerten Oszillator (2) in einer Phasensperr-Schleifenanordnung zu erhalten, mit Einrichtungen (16, 22, 23) zum Anlegen eines Modulationssignals mit dem Steuersignal an einen Steuereingang des spannungsgesteuerten Oszillators (2) und Integriereinrichtungen (24, 26, 28) zum Anlegen des Modulationssignals zum Steuern des veränderlichen Teilungsfaktors des Umsetzschaltkreis, **dadurch gekennzeichnet**, daß die Integriereinrichtungen (24, 26, 28) einen Auf- und Abzähler (50) umfassen, dessen Übertrag-/Borgbetrag-Signale mit einem weiteren Zähler (60) gekoppelt sind, dessen Ausgang seinerseits mit dem Umsetzschaltkreis (4) gekoppelt ist, und daß der Zählwert des Auf- und Abzählers (50) an einen Schaltkreis (52, 54) angelegt ist, der einen Puls variabler Breite erzeugt, der über einen Impulsfrequenzumsetzer (30) an einer Summiereinrichtung (12) zum Aufsummieren mit dem Ausgang des Vergleichers (6) anliegt.

2. Frequenzsynthesizer nach Anspruch 1, **dadurch gekennzeichnet**, daß die Einrichtungen (16, 22, 23) zum Anlegen des Modulationssignals mit dem Steuersignal an einen Steuereingang des spannungsgesteuerten Oszillators (2) einen Gauß-Tiefpaßfilter (22) umfassen, um eine GMSK (Gaussian minimum shift keying)-Modulation zu erzeugen.

3. Frequenzsynthesizer nach Anspruch 1 oder 2, **dadurch gekennzeichnet**, daß der Umsetzschaltkreis (4) Steuereinrichtungen (44, 46, 48) zum Erzeugen von Teilungsfaktoren N und N + 1 umfaßt, und daß der Ausgang des weiteren Zählers (60) die relative Anzahl der Zyklen des Umsetzschaltkreises (4) steuert, während denen die Teilungsfaktoren N und N + 1 angewandt werden.

4. Frequenzsynthesizer nach jedem der voranstehenden Ansprüche 1 bis 3, **dadurch gekennzeichnet**, daß der Umsetzschaltkreis (4) einen ersten Zähler (42) zum Bestimmen eines Nominalwertes für den Teilungsfaktor umfaßt, einen Vorimpulsfrequenzumsetzer-Schaltkreis (48), der für den Empfang des Ausgangssignals von dem spannungsgesteuerten Oszillator (2) gekoppelt ist und einen Aufnahmezähler (44), der das Umschalten des Vorimpulsfrequenzumsetzer-Schaltkreises (48) zwischen den Betriebsweisen ermöglicht, die die Teilungsfaktoren, bzw. N + 1 bestimmen.

5. Frequenzsynthesizer nach Anspruch 4, **dadurch gekennzeichnet**, daß der weitere Zähler (60) ein Ausgangssignal zum Steuern des Umschaltens des Vorimpulsfrequenzumsetzer-Schaltkreises (48) liefert.

6. Frequenzsynthesizer nach Anspruch 5, **dadurch gekennzeichnet**, daß der weitere Zähler (60) ein Ausgangssignal zum Umschalten des Vorimpulsfrequenzumsetzer-Schaltkreises (48) in Gestalt eines Pulses liefert, dessen Länge von dem Zählwert des weiteren Zählers (60) abhängt.

**Revendications**

1. Synthétiseur de fréquence, comprenant un oscillateur commandé en tension (2), un oscillateur de référence (8), un circuit diviseur (4) destiné à diviser la fréquence d'un signal de sortie de l'oscillateur commandé en tension (2) par un facteur variable de division, un comparateur (6) destiné à comparer un signal de sortie du circuit diviseur (4) à un signal de sortie de l'oscillateur de référence (8) pour la création d'un signal de commande de l'oscillateur commandé en tension (2) dans un ensemble à boucle verrouillée en phase, un dispositif (16, 22, 23) destiné à appliquer un signal de modulation avec le signal de commande à une entrée de commande de l'oscillateur commandé en tension (2) et un dispositif intégrateur (24, 26, 28) destiné à appliquer le signal de modulation pour la commande du facteur de diviseur variable du circuit diviseur (4), caractérisé en ce que le dispositif intégrateur (24, 26, 28) comprend un compteur-décompteur (50) dont les sorties de report-retenue sont couplées à un dispositif compteur supplémentaire (60) dont le signal de sortie est transmis à son tour au circuit diviseur (4), et en ce que la valeur du compteur-décompteur (50) est appliquée à un circuit (52, 54) destiné à produire une impulsion de largeur variable qui est appliquée par un dispositif de changement d'échelle (30) à un dispositif de sommation (12) destiné à l'ajouter au signal de sortie du comparateur (6).

2. Synthétiseur selon la revendication 1, dans lequel le dispositif (16, 22, 23) d'application du signal de modulation avec le signal de commande à une entrée de commande de l'oscillateur commandé en tension (2) comprend un filtre passe-bas gaussien (22) destiné à produire une modulation GMSK.

3. Synthétiseur selon la revendication 1 ou 2, dans lequel le circuit diviseur (4) comporte un circuit de commande (44, 46, 48) destiné à produire les facteurs de division N et N+1, et le signal de sortie du dispositif compteur supplémentaire (60) est destiné à commander le nombre relatif de cycles du circuit diviseur (4) pendant lesquels les facteurs de division N et N+1 sont utilisés.

4. Synthétiseur selon l'une quelconque des revendications précédentes, dans lequel le circuit diviseur (4) comprend un premier compteur (42) destiné à déterminer une valeur nominale du facteur de division, un circuit de changement préalable d'échelle (48) couplé afin qu'il reçoive le signal de sortie de l'oscillateur commandé en tension (2), et un compteur (44) destiné à permettre à la commutation du circuit le changement préalable d'échelle (48) entre des modes déterminants des facteurs de division respectivement N+1.

5. Synthétiseur selon la revendication 4, dans lequel le dispositif compteur supplémentaire (60) transmet un signal de sortie destiné à commander la commutation du circuit de changement préalable d'échelle (48).

6. Synthétiseur selon la revendication 5, dans lequel le dispositif compteur supplémentaire (60) transmet le signal de sortie destiné à commander la commutation du circuit de changement préalable d'échelle (48) sous forme d'une impulsion dont la longueur dépend de la valeur comptée par le dispositif compteur supplémentaire (60).

Fig. 1.

TWO POINT MODULATED SYNTHESISER WITH N COUNTER MODULATION
(APPROXIMATIONS USED FOR IMPLEMENTATION)

Fig. 2.

GMSK MODULATED SYNTHESISER (VCO &'÷N'MODULATION)

Fig. 2(cont.)

EP 0 408 238 B1